Europäisches Patentamt

(19) European Patent Office

Office européen des brevets

(11) Publication number: **0 006 468**
B1

(12) # EUROPEAN PATENT SPECIFICATION

(45) Date of publication of patent specification: **15.12.82**

(51) Int. Cl.³: **G 06 F 5/04, H 04 L 25/45**

(21) Application number: **79101695.9**

(22) Date of filing: **01.06.79**

(54) Parallel to series data converters.

(30) Priority: 30.06.78 US 921141

(43) Date of publication of application:
09.01.80 Bulletin 80/1

(45) Publication of the grant of the patent:
15.12.82 Bulletin 82/50

(84) Designated Contracting States:
DE FR GB IT

(56) References cited:
FR - A - 2 344 073
FR - A - 2 348 611

L'ONDE ELECTRONIQUE, vol. 44, no. 446, May
1964, pages 535—540.
Paris FR
ANTOINE: "Traitement de l'information.
Analyseur multiparamétrique"

(73) Proprietor: International Business Machines
Corporation
Armonk, N.Y. 10504 (US)

(72) Inventor: Allen, Francis Kempton
1398 Cerro Verde
San Jose California 95120 (US)
Inventor: Chin, Victor Huie
1215 Serene Valley Court
San Jose California 95120 (US)

(74) Representative: Lewis, Alan John
IBM United Kingdom Patent Operations Hursley
Park
Winchester, Hants, SO21 2JN (GB)

## Parallel to series data converters

The invention relates to converters for converting groups of data supplied in parallel to a serial stream of data occuring at a predetermined data rate.

French specification No. 2348611 (Marie) and corresponding Canadian specification No. 1081816 disclose a data transmission system including a converter for converting parallel binary data to serial data. The Marie converter comprises two stores for receiving alternately successive groups of $n$ data bits from a stream of input data comprising $n$ bits in parallel and $n$ inverter circuits connected respectively to receive the data signal outputs of both of the stores. Clock means provide clock signals defining cyclic periods comprising $n$ equal data intervals and cause operation of transmission control means. The control means operate in timed relationship with the clock signals and control the two stores, the inverter circuits and a multiplexor so as to make available at the output of the multiplexor the output of one of the stores during alternate cycle periods and that of the other store during the intervening cycle periods and for enabling input data to be entered in said one store during said intervening cycle periods and for enabling input data to be entered in said one store during said intervening cycle periods and in said other store during said alternate cycle periods.

The multiplexor is connected to receive the data output of the $n$ inverter circuits and operates in synchronism with the clock signals so that each inverter circuit passes the data signal received thereby to a common output during contiguous data intervals defined by the clock signals.

In the Marie converter the inverter circuits and the multiplexor are operated in synchronism at the repetition rate of a train of timing pulses running at the data rate of the serial output data stream. This necessitates the use of high-speed/high cost circuitry which is a disadvantage. A further disadvantage is that the data read from either store is supplied directly to the data output line and is not buffered and sampled in any way. This can cause interruption of the output data stream, e.g. due to switching hazard or error. A further disadvantageous feature of the Marie converter is the use of a second group of $n$ inverter circuits. These circuits receive the parallel incoming data and are connected to both the stores, either directly or through further multiplexors. These second inverter circuits and, when present, the further multiplexors have to operate at the repetition rate of the parallel incoming data and again require high speed/high cost circuitry.

It is an object of the present invention to provide an improved parallel to series data converter. In particular it is an object to provide such a converter in which many individual circuits are not required to operate at the repetition rate of the output serial data so that relatively slowly operating circuitry can be used while relatively high output data repetition rates can be achieved. It is a further particular object to provide a converter, as aforesaid, in which the risk of the serial output data being interrupted albeit momentary, is reduced.

Accordingly the invention provides a converter for converting parallel binary data to serial data, said converter comprising two $n$ position input registers for receiving alternately successive groups of $n$ data bits from a stream of input data comprising $n$ bits in parallel; $n$ steering circuits connected respectively to receive the $n$ data signal outputs of both of the input registers; clock means for providing clock signals defining a group cycle period comprising $n$ equal data intervals; control means, operable in timed relationship with the clock signals, for the two input registers and the steering circuits for making available at the output of the steering circuits the output of one of the registers during alternate group cycle periods and that of the other register during the intervening group cycle periods and for enabling input data to be entered in said one register during said intervening group cycle periods and in said other register during said alternate group cycle periods; and $n$ sampling and interleaving circuits respectively connected to receive the $n$ data signal output of the $n$ steering circuits and respectively receiving and being controlled in synchronism with the clock signals so that each interleaving circuit passes the data signal received thereby to a common output during a data interval associated therewith, said converter being characterised by comprising a counter, incremented in timed relationship to the clock signals, and providing two out-of-phase sequences of gating signals, the gating signals recurring at half the group cycle period, and being further characterised in that the $n$ steering circuits are arranged in two groups which respectively receive and are controlled by the two sequences of gating signals so that one group passes the data signals received thereby during one half of a time interval equal to a group cycle period and the other group passes the data signals received thereby during the other half of the time interval.

The invention also provides a high speed serializer to produce from parallel data a serial data stream at a predetermined data rate comprising means for producing a series of clock pulses recurrent at the predetermined data rate; a plurality of stores for storing successive groups of the parallel data; a plurality of data steering networks connected to receive the outputs from the stores; a serializer register; and means for interleaving the data from the steering networks sequentially into said serializer register to form a serial data stream at the predetermined data rate, said serializer being characterised by further comprising means for generating from said clock pulses a first series of spaced overlapping pulses recurrent at a rate which is a sub-multiple of said data rate; means for generating from said clock pulses a second series of spaced non-overlapping pulses recurrent at a rate which is double the rate of said first series of spaced pulses; and being further characterised in that the steering networks include first control circuitry, responsive to the pulses of the second series of pulses, for steering each group of data from the stores to the interleaving means in a plurality of subgroups, the sub-groups being supplied to the interleaving means at different times; and in that the interleaving means includes second control circuitry, responsive to the first series of pulses, for controlling the transfer of the data sub-groups from the steering networks to the serializer register.

A parallel to series converter embodying the invention will now be described by way of example with reference to the accompanying drawings, in which:—

FIGURE 1 is a block diagram of the parallel-to-serial converter embodying the invention;

FIGURE 2 is a schematic circuit diagram of one of the steering circuits used in the FIG. 1 converter;

FIGURE 3 is a series of timing waveforms illustrating the phase relationships of the processed signals; and

FIGURE 4 is a schematic block circuit diagram of the sampling and interleaving circuit used in the FIG. 1 converter.

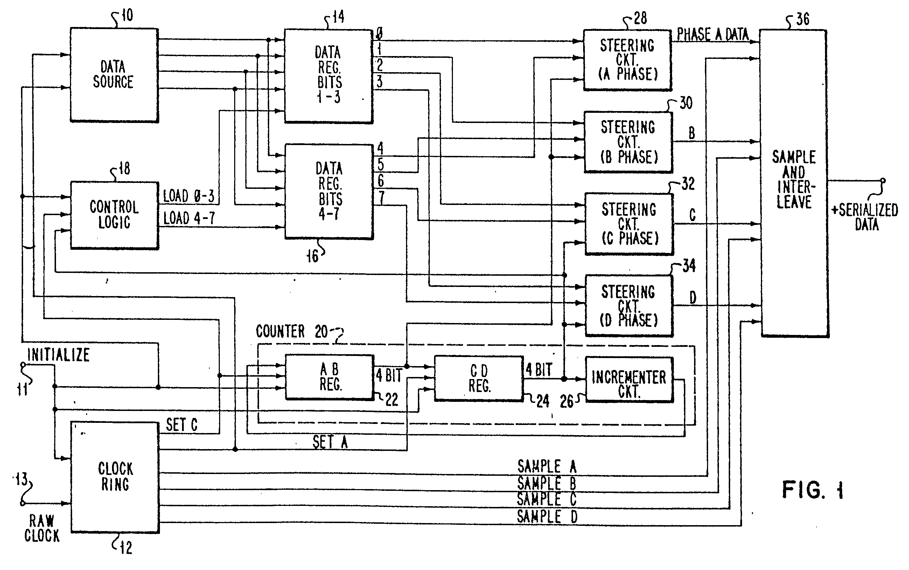

With reference to FIG. 1, a data source 10 provides half-bytes of binary information in a parallel-by-bit, serial-by-half-byte manner, and this information is converted into a fully serialized output data stream by the parallel-to-serial converter of this invention. A half-byte of data is four bits of binary data. The data source 10 may be a central processor, a disk store or other device which stores or generates binary data. To aid in the explanation of this invention, it is assumed that when the data source 10 is pulsed with an "initialize" signal 11, derived, for example, from an external control unit (not shown), or a "set A" clocking signal from a clock ring 12, that a new half-byte of parallel data is made available at the output of the data source 10 and that this data will remain stable until it is loaded into either data register 14 or data register 16.

Each data register 14 or 16 consists of latch circuits which can store, in parallel, one half-byte of data from the data source 10. Data register 14 will be loaded with new data when it senses a "Load 0—3" signal from control logic 18. Data register 16 will be loaded with new data when it senses a "Load 4—7" signal from the control logic 18. The control logic 18 utilizes clocking information, i.e., "set C" from the clock ring 12; steering information "CD Reg bit 4" from a counter 20; and the "initialize" signal 11 to generate the "Load 0—3" and "Load 4—7" signals. These signals are timed such that they cause alternate loading of the data registers 14 and 16. The loading of one data register 14 or 16 is accomplished while the data stored in the other data register is held steady for parallel-to-serial conversion. The "initialize" signal causes the control logic 18 to issue a "load 0—3" signal and thereby causes the data register 14 to be loaded with the first half-byte of data from the data source 10 prior to the actual start of the serialization process.

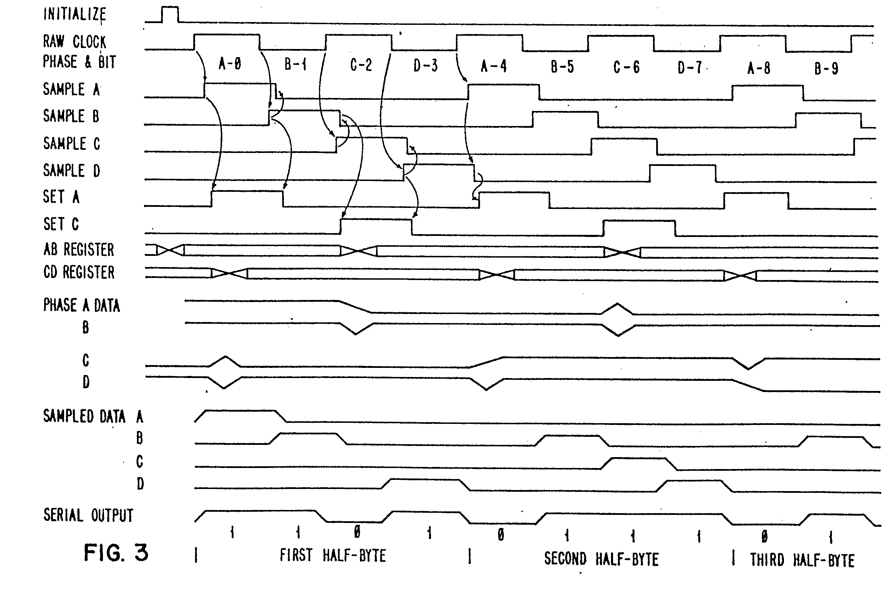

In greater detail, and with references to FIGS. 1 and 3, the parallel-to-serial converter of this invention includes a clock ring 12, which receives a raw clock signal 13 from an external source (not shown). The raw clock signal will control the rate at which data bits are serialized such that one bit is serialized for each alteration of the raw clock signal. The raw clock signal may alternate at a regular or irregular rate according to the requirements of the specific system in which this invention is applied. However, it is illustrated in FIG. 3 as having approximately equal time durations for each alternation.

The clock ring 12 is basically a one-of-four type ring circuit which has two groups of output timing signals. The first group provides four signals called "Sample" outputs ("Sample A", "Sample B", "Sample C", and "Sample D"). These are caused to turn "ON" one at a time, in the cyclic sequence .A.B.C.D.A.B. . . ., each time an alteration of the raw clock signal is detected. As each sample output of the clock ring turns "ON", the new sample current forces the prior one to be turned "OFF" immediately. However, there is a slight timewise overlap of the "ON" sample pulses.

The second group has two outputs called "Set A" and "Set C". "Set A" turns "ON" only after "Sample D" has turned "OFF", and it turns "OFF" at approximately the same time as "Sample A" is turned "OFF", but, in any case, well before "Sample C" is turned "ON". "Set C" has similar timing except that it is displaced by two phases.

The counter 20 includes an AB register 22, a CD register 24, and an incrementing circuit 26 coupled in a closed loop. Parallel binary count information advances through the loop as the AB register 22 and CD register 24 are alternately reloaded by the application of "Set C" and "Set A" pulses respectively. The incrementer circuit 26 causes the binary value of the count to be incremented by 4 each time the AB register 22 is loaded.

In FIG. 1, only the 4 bit of the parallel binary count is shown. Because the clock ring, in effect, counts the values 0, 1, 2, and 3 in the serialization process, there is no need for the generation of binary bits of weights 1 and 2 by the counters. Thus, the lowest order bit produced by the counter is weighted binary 4. Parallel count bits higher than binary 4 are not pertinent to the basic system illustrated in FIG. 1, but may be required in similar type systems having greater complexity.

Steering networks 28, 30, 32, 34 are four functionally similar steering networks that are used for the serialization process. The Phase A data and Phase B data steering networks 28 and 30 are controlled by the AB Register 22 of the counter 20. The Phase C data and Phase D data steering networks 32 and 34 are controlled by the CD Register 24 of the counter 20. Phases A, B, C and D may be considered as sub-phases. This arrangement permits slower counter operation and requires fewer counter registers than would otherwise be required to obtain the speed of operation required.

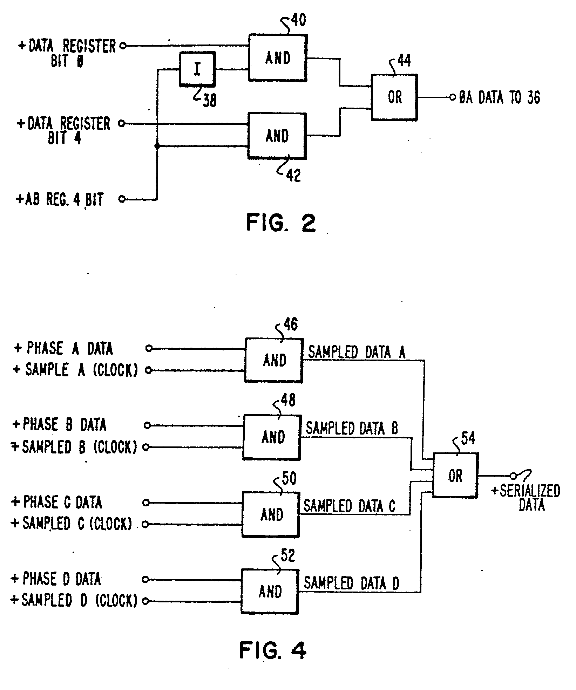

The configuration of a typical steering network is illustrated in FIG. 2. The A phase steering circuit 28 illustrated in FIG. 2 receives bit 0 and bit 4 data from data registers 14 and 16 respectively. The AB register 22 supplies a binary weighted 4 bit that reverses in polarity for each half byte cycle. When the 4 bit signal is negative, an inverter 38 passes a positive or high signal to an AND gate 40. Data bit 0 is passed through gate 40, to logic OR circuit 44, and provides an output signal to the sample and interleave circuit 36. In accordance with convention, if data bit 0 has a binary 1 value, then a data pulse will be seen by circuit 36. On the other hand, if data bit 0 has a binary 0 value, this will be indicated by the absence of a pulse at the output of the steering circuit 28 and sample circuit 36.

During the half-byte cycle when the polarity of the binary weight 4 bit from the AB register 22 is positive, AND gate 42 is opened to allow data bit 4 from the half-byte data register 16 to pass. Similarly, the binary value of data bit 4 appears at the output of OR gate 44 for subsequent sampling and serial interleaving by circuit 36.

Steering circuits 30, 32 and 34 operate in the same manner as circuit 28. However, steering circuit 30 processes data bits 1 and 5 respectively from data registers 14 and 16 during Phase B time. Steering circuit 32 processes data bits 2 and 6, and circuit 34 receives data bits 3 and 7. Circuits 32 and 34 receive the binary weighted 4 bit from the CD register 24, during Phase C and D times respectively.

The input signals to the network illustrated in FIG. 2 are those required for the steering network 28 which steers Phase A data. Each of the four data steering networks is capable of selecting one of two data bits from the data registers 14 and 16. The bit selected is determined by the value of the count currently stored in the AB or CD registers 22 and 24 which are to be serialized during the Phase A or Phase B times, as shown in FIG. 3. The CD register 24 is similarly used to select data which are to be serially processed during the next Phase C or Phase D times. The AB register 22 and CD register 24 operate in phase quadrature to each other. However, each register changes state at half the rate that would be required of a two phase system if such a system were handling the same data rate as that of the system described herein. The count value in these registers changes once for each four phase revolution of the clock ring.

As shown in FIG. 2, the data bit stored in the Bit 0 position of the data register is selected by the steering network 28 when the AB Register 4 bit is "OFF", and the data bit stored in the Bit 4 position of the data register is selected when the AB register 4 Bit is "ON". The 4 data bits selected by the data steering networks are called Phase A data, Phase B data, Phase C data, and Phase D data. The outputs of the steering networks are sampled by an appropriate clocking pulse (i.e., "Sample A" is used to sample Phase A data) and the four data streams are interleaved to form the serial data stream.

The sample and interleave circuit 36 is shown in FIG. 4. The sampling pulses for adjacent pulses are designed to slightly overlap with respect to time, as previously mentioned, so that switching hazards will not occur in the serial output data stream.

It should be noted that the A Phase and B Phase data at the output of the steering networks 28 and 30 are timewise in parallel relation to each other. Similarly, the C Phase and D Phase data at the output of the steering networks 32 and 34 are in parallel relation to each other. However, the two parallel groups of data. A Phase——B Phase and C Phase——D Phase are in two phase quadrature.

The sample and interleave circuit 36 receives phase data A, B, C and D from the steering circuits 28, 30, 32, 34 in a two-bit-parallel, serial-two-phase fashion, as described supra. As shown in FIG. 4, the phase data A, B, C, D are applied respectively to AND gates 46, 48, 50 and 52. The clock sample pulses A, B, C, D from clock ring 12 are cyclically applied to the AND gates 46——52 to pass serially the data seen at the inputs of the gates 46——52. The serial data is fed through logic OR 54 where the serial data bits are interleaved. The serial data at the output of logic OR 54 is available for further utilization.

By virtue of providing timing control registers for half-bytes of parallel stored data, and phase control to serialize the data, a simplified and relatively inexpensive parallel-to-serial converter may be realized.

In this embodiment, data in parallel in groups are serially sampled by a number of sample pulses equal to the number of data bits in each group. It is apparent that the invention is not limited to a specific number of data bits in any parallel group, or to any number of parallel groups.

Claims

1. A converter for converting parallel binary data to serial data, said converter comprising two $n$ position input registers (14, 16) for receiving alternately successive groups of $n$ data bits from a stream of input data comprising $n$ bits in parallel; $n$ steering circuits (28, 30, 32, 34) connected respectively to receive the $n$ data signal outputs of both of the input registers; clock means (13) for providing clock signals defining a group cycle period comprising $n$ equal data intervals; control means, operable in timed relationship with the clock signals, for the two input registers (14, 16) and the steering circuits (28, 30, 32, 34) for making available at the output of the steering circuits the output of one of the registers during alternate group cycle periods and that of the other register during the intervening group cycle periods and for enabling input data to be entered in said one register during said intervening group cycle periods and in said other register during said alternate group cycle periods; and $n$ sampling and interleaving circuits (36) respectively connected to receive the $n$ data signal output of the $n$ steering circuits and respectively receiving and being controlled in synchronism with the clock signals so that each interleaving circuit passes the data signal received thereby to a common output during a data interval associated therewith, said converter being characterised by comprising a counter (20), incremented in timed relationship to the clock signals, and providing two out-of-phase sequences of gating signals, the gating signals recurring at half the group cycle period, and being further characterised in that the $n$ steering circuits are arranged in two groups (28, 30; 32, 34) which respectively receive and are controlled by the two sequences of gating signals so that one group passes the data signals received thereby during one half of a time interval equal to a group cycle period and the other group passes the data signals received thereby during the other half of the time interval.

2. A converter as claimed in claim 1, further characterised by comprising means (12) for deriving from said clock signals $n$ pulse trains (Sample A, B, C, D), each having a pulse repetition rate equal to the serial output data rate, and in that the sampling interleaving circuits include gating circuitry (46, 48, 50, 52, FIG. 4) responsive to the $n$ pulse trains, to gate the data signals to the common output, as aforesaid.

3. A converter as claimed in claim 1 or 2, further characterised in that the pulses of the two out-of-phase sequences of gating pulses do not overlap in time while successive ones of the $n$ pulse trains (Samples A and B; samples B and C, samples C and D, samples D and A) do overlap in time to ensure continuity in the output data.

4. A converter as claimed in claim 1, 2 or 3, further characterised in that the counter (20) comprises two counting registers (AB, CD) connected in series with each other and an incrementing circuit (26) connected in a feedback loop from the output of the second of the counting registers (CD) to the input of the first counting register (AB).

5. A converter as claimed in any one of claims 1 to 4, further characterised in that the clock comprises a source of timing pulses and an $n$ stage clocking ring stepped by the timing pulses.

6. A converter as claimed in any one of claims 1 to 5, in which the $n$ bits comprise a half byte of a $2\,n$ bit word, further characterised in that, in use, parallel half-byte inputs are received by the converter at time spacings equal to the group cycle period of $n$ data intervals and the output data comprises a stream of consecutive data bits having centre separations equal to the data interval.

7. A high speed serializer to produce from parallel data a serial data stream at a predetermined data rate comprising means (13) for producing a series of clock pulses recurrent at the predetermined data rate; a plurality of stores (14, 16) for storing successive groups of the parallel data; a plurality of data steering networks (28, 30, 32, 34) connected to receive the outputs from the stores (14, 16); a serializer register; and means (36) for interleaving the data from the steering networks (28, 30, 32, 34) sequentially into said serializer register to form a serial data stream at the predetermined data rate, said serializer being characterised by further comprising means (12) for generating from said clock pulses a first series of spaced overlapping pulses (Sample A, B, C, D) recurrent at a rate which is a submultiple of said data rate; means (20) for generating from said clock pulses a second series of spaced non-overlapping pulses recurrent at a rate which is double the rate of said first series of spaced pulses; and being further characterised in that the steering networks (28, 30, 32, 34) include first control circuitry (38, 40, 42, 44 FIG. 2), responsive to pulses (AB reg) of the second series of pulses, for steering each group of data from the stores (14, 16) to the interleaving means (36) in a plurality of sub-groups, the sub-groups being supplied to the interleaving means at different times; and in that the interleaving means (36) includes second control circuitry (46, 48, 50, 52 FIG. 4) responsive to the first series of pulses, for controlling the transfer of the data sub-groups from the steering networks (28, 30, 32, 34) to the serializer register.

Revendications

1. Convertisseur parallèle/série de données binaires, comportant deux registres d'entrée (14, 16) à $n$ positions destinés à recevoir de façon alternée des groupes successifs de $n$ bits de données d'une suite de données d'entrée comprenant n bits en parallèle; n circuits de commande (28, 30, 32, 34) respectivement connectés de manière à recevoir les sorties des deux registres d'entrée constituées par n signaux de données; une horloge (13) fournissant des signaux d'horloge qui définissent une période cyclique composée de n intervalles égaux de temps-bits de données; des moyens de commande, fonctionnant en synchronisme avec les signaux d'horloge, des deux registres d'entrée (14, 16) et des circuits de commande (28, 30, 32, 34) de telle sorte que l'on obtienne à la sortie des circuits de commande la sortie de l'un des registres, une période cyclique sur deux, et celle de l'autre registre, toutes les périodes cycliques restantes, et que les données d'entrée puissent être chargées dans le premier registre pendant ces dernières périodes cycliques et dans l'autre registre pendant les autres périodes cycliques; et n circuits d'échantillonnage et d'imbrication (36) respectivement connectés de manière à recevoir la sortie des n circuits de commande constituée par les n signaux de données et recevant respectivement les signaux d'horloge et fonctionnant en synchronisme avec ces derniers, de telle sorte que chaque circuit d'échantillonnage et d'imbrication transmette le signal de données reçu à une sortie commune pendant un intervalle de temps associé, ledit convertisseur étant caractérisé en ce qu'il comprend un compteur (20), incrémenté en synchronisme avec les signaux d'horloge; en ce qu'il fournit deux suites déphasées de signaux de porte qui apparaissent à chaque demi-période cyclique; et en ce que les n circuits de commande sont répartis en deux groupes (28, 30; 32, 34) qui reçoivent respectivement les deux suites de signaux de porte et sont commandés par celles-ci de telle sorte que l'un desdits groupes transmette les signaux de données reçus pendant un intervalle de temps correspondant à la moitié de ladite période cyclique et que l'autre groupe transmette les signaux de données reçus pendant l'autre moitié de ladite période.

2. Convertisseur selon la revendication 1, caractérisé en outre en ce qu'il comprend des moyens (12) permettant d'obtenir, à partir desdits signaux d'horloge, n trains d'impulsions (échantillons A, B, C, D) dont chacun présente une cadence de répétition égale à la cadence d'apparition des données de sortie série, et en ce que les circuits d'échantillonnage et d'imbrication comprennent des circuits de porte (46, 48, 50, 52, figure 4) permettant, en réponse aux n trains d'impulsions, de transférer les signaux de données à la sortie commune, de la façon précédemment décrite.

3. Convertisseur selon la revendication 1 ou 2, caractérisé en outre en ce que les impulsions des deux suites déphasées d'impulsions de porte ne se chevauchent pas dans le temps, cependant que les n trains d'impulsions successifs (échantillons A et B; échantillons B et C;

échantillons C et D; échantillons D et A) se recouvrent dans le temps pour assurer la continuité des données de sortie.

4. Convertisseur selon la revendication 1, 2 ou 3, caractérisé en outre en ce que le compteur (20) comporte deux registres de comptage (AB, CD) mutuellement connectés en série, et un circuit d'incrémentation (26) connectée entre la sortie du second desdits registres (CD) et à l'entrée du premier desdits registres (AB).

5. Convertisseur selon l'une quelconque des revendications 1 à 4, caractérisé en outre en ce que l'horloge comprend une source d'impulsions chronologiques et un circuit en anneau à n étages que lesdites impulsions font progresser.

6. Convertisseur selon l'une quelconque des revendications 1 à 5, caractérisé en ce que les n bits constituent un demi-multiplet d'un mot de 2 n bits, et en ce que, en fonctionnement normal, des entrées constituées par des demi-multiplets de données transmises en parallèle sont reçues par le convertisseur et sont séparées par des intervalles de temps égaux à ladite période cyclique composée de n intervalles de temps-bits de données, les données de sortie constituant une suite de bits de données consécutifs séparés par des intervalles égaux à un intervalle de temps-bit de données.

7. Convertisseur parallèle/série à vitesse de fonctionnement élevée pour convertir des données transmises en parallèle en une suite de données série à une cadence prédéterminée, comportant des moyens (13) permettant de fournir des impulsions d'horloge à ladite cadence prédéterminée; plusieurs mémoires (14, 16) pour emmagasiner des groupes successifs de données transmises en parallèle; plusieurs circuits de commande de données (28, 30, 32, 34) connectés de manière à recevoir les sorties desdites mémoires (14, 16); un registre de conversion parallèle/série; et des moyens (36) pour imbriquer les données provenant desdits circuits de commande (28, 30, 32, 34) et les introduire de façon séquentielle dans ledit registre pour former une suite de données série à ladite cadence prédéterminée, ledit convertisseur étant caractérisé en ce qu'il comprend en outre des moyens (12) permettant d'engendrer, à partir desdites impulsions d'horloge, une première suite d'impulsions (échantillons A, B, C, D) se recouvrant à une cadence qui est un sous-multiple de ladite cadence prédéterminée; des moyens (20) permettant d'engendrer, à partir desdites impulsions d'horloge, une seconde suite d'impulsions qui ne se recouvrent pas, à une cadence qui est égale au double de la cadence à laquelle est engendrée ladite première suite d'impulsions; en ce que les circuits de commande (28, 30, 32, 34) comprennent un premier ensemble de circuits de commande (38, 40, 42, 44, figure 2) qui, en réponse aux impulsions (reg. AB) de la seconde suite d'impulsions, commande le transfet de chaque groupe de données des mémoires (14, 16) auxdits moyens d'imbrication (36) en plusieurs sous-groupes, les transferts étant effectués à différents instants; et en ce que lesdits moyens d'imbrication (36) comprennent un second ensemble de circuits de commande (46, 48, 50, 52, figure 4) permettant, en réponse à la première suite d'impulsions, de commander le transfert des sous-groupes de données des circuits de commande (28, 30, 32, 34) au registre de conversion parallèle/série.

**Patentansprüche**

1. Konverter zum Umsetzen paralleler Binärdaten in serielle Daten mit folgenden Merkmalen: Zwei Eingangsregister (14, 16) mit $n$ Positionen, die abwechselnd aufeinanderfolgende Gruppen von $n$ Datenbits aus einem Strom von Eingangsdaten empfangen, der $n$ Bits in Paralleldarstellung führt; $n$ Verteilerschaltkreise (28, 30, 32, 34), die jeweils so geschaltet sind, daß sie $n$ Datensignalausgänge beider Eingangsregister empfangen; Takteinrichtungen (13) zur Abgabe von Taktsignalen, die eine Gruppentaktperiode mit $n$ gleichen Datenintervallen definieren; Steuereinrichtungen für die beiden Eingangsregister (14, 16) und die Verteilerschaltkreise (28, 30, 32, 34), die in zeitlicher Beziehung mit den Taktsignalen betreibbar sind, um am Ausgang der Verteilerschaltkreise das Ausgangssignal eines der Register während abwechselnder Gruppentaktperioden verfügbar machen und den Ausgang des anderen Registers während der dazwischenliegenden Gruppentaktperioden und um die Eingangsdaten für die Eingabe in das eine Register während der dazwischenliegenden Gruppentaktperioden und in das andere Register während der abwechselnden Gruppentaktperioden einzugeben; und $n$ Abtast- und Verschachtelungsschaltkreise (36), die jeweils so geschaltet sind, daß sie das $n$ Datenausgangssignal der $n$ Verteilerschaltkreise empfangen sowie jeweils Taktsignale zur synchronen Steuerung, so daß jeder Verschachtelungsschaltkreis die empfangenen Datensignale während eines dazugehörigen Datenintervalls an einen gemeinsamen Ausgang abgibt, dadurch gekennzeichnet, daß ein Zähler (20) vorgesehen ist, der in zeitlicher Beziehung mit den Taktsignalen erhöht wird und zwei phasenverschobene Folgen von Steuersignalen abgibt, die mit der halben Gruppentaktperiode wiederholt werden und daß die $n$ Verteilerschaltkreise in zwei Gruppen (28, 30; 32, 34) angeordnet sind, die jeweils die beiden Folgen von Steuersignalen empfangen und von diesen so gesteuert werden, daß die eine Gruppe die dabei empfangenen Datensignale während einer Hälfte eines Zeitintervalls weiterleitet, das gleich einer Gruppentaktperiode ist und die andere Gruppe die dabei empfangenen Datensignale während der anderen Hälfte des Zeitintervalls.

2. Konverter nach Anspruch 1, dadurch gekennzeichnet, daß Vorrichtungen (12) vorgesehen sind, mit denen $n$ Impulszüge (Sample A, B, C, D) aus den Taktsignalen abgeleitet werden, von denen jeder eine Impulswiederholungsrate aufweist, die gleich der seriellen Ausgangsdatenrate ist und daß die Abtast- und Verschachtelungsschaltkreise Torschaltungen (46, 48, 50, 52; Fig. 4) aufweisen, die von den $n$ Impulszügen beaufschlagt werden, um in der vorbeschriebenen Weise die Datensignale zum gemeinsamen Ausgang zu leiten.

3. Konverter nach Anspruch 1 oder 2, dadurch gekennzeichnet, daß die Impulse der beiden phasenverschobenen Folgen von Steuerimpulsen zeitlich nicht überlappen, während aufeinanderfolgende Impulse der $n$ Impulszüge (Samples A und B; Samples B und C; Samples C und D; Samples D und A) zeitlich überlappen, um die Kontinuität der Ausgangsdaten sicherzustellen.

4. Konverter nach einem der Ansprüche 1 bis 3, dadurch gekennzeichnet, daß der Zähler (20) zwei Zählregister (AB, CD) enthält, die in Reihe miteinander und zu einem Schaltkreis (26) zur Erhöhung des Zählers geschaltet sind, der in einer Rückkoppelschleife vom Ausgang des zweiten Zählregisters (CD) zum Eingang des ersten Zählregisters (AB) geschaltet ist.

5. Konverter nach einem der Ansprüche 1 bis 4, dadurch gekennzeichnet, daß der Taktgeber eine Quelle von Zeitimpulsen und einen $n$-stufigen Taktring enthält, der von den Zeitimpulsen weitergeschaltet wird.

6. Konverter nach einem der Ansprüche 1 bis 5, in dem die $n$ Bits ein Halb-Byte eines $2n$-Bit Wortes darstellen, dadurch gekennzeichnet, daß bei der Benutzung parallele, ein Halb-Byte darstellende Eingänge vom Konverter in zeitlichen Abständen empfangen werden, die gleich der Gruppentaktperiode von $n$ Datenintervallen sind und daß die Ausgangsdaten einen Strom aufeinanderfolgenden Datenbits enthalten, deren Mittenabstände gleich dem Datenintervall sind.

7. Hochgeschwindigkeits-Serialisiereinrichtung zur Erzeugung eines seriellen Datenstroms mit einer vorbestimmten Datenrate aus parallelen Daten mit folgenden Merkmalen: eine Vorrichtung (13) zur Erzeugung einer Folge von Taktimpulsen, die sich mit der vorherbestimmten Datenrate wiederholen; eine Vielzahl von Speichern (14, 16), in denen aufeinanderfolgende Gruppen der parallelen Daten gespeichert werden; eine Vielzahl von Datenverteilungsnetzwerken (28, 30, 32, 34), die so geschaltet sind, daß sie die Ausgänge von den Speichern (14, 16) empfangen; ein Serialisierregister; und eine Vorrichtung (36), mit der die Daten aus den Verteilernetzwerken (28, 30, 32, 34) sequentiell in die Serialisierregister verschachtelt werden, um einen seriellen Datenstrom mit der vorherbestimmten Datenrate zu erzeugen, gekennzeichnet durch die folgenden weiteren Merkmale: eine Vorrichtung (12), mit der aus den Taktimpulsen eine erste Folge von räumlich getrennten, zeitlich überlappenden Impulsen (Sample A, B, C, D) erzeugt werden, die sich mit einem Bruchteil der Datenrate wiederholen; eine Vorrichtung (20), mit der aus den Taktimpulsen eine zweite Folge von räumlich getrennten, zeitlich nicht überlappenden Impulsen erzeugt wird, die sich mit der doppelten Rate der ersten Folge von Impulsen wiederholen; wobei die Verteilernetzwerke (28, 30, 32, 34) erste Steuerschaltungen (38, 40, 42, 44; Fig. 2) enthalten, die auf Impulse (AB REG) der zweiten Folge von Impulsen reagieren, um jede Gruppe von Daten aus den Speichern (14, 16) in die Verschachtelungseinrichtung (36) in einer Vielzahl von Untergruppen zu steuern, wobei die Untergruppen zu verschiedenen Zeiten an die Verschachtelungseinrichtungen gegeben werden; und daß die Verschachtelungseinrichtung (36) zweite Steuerschaltungen (46, 48, 50, 52; Fig. 4) enthält, die auf die erste Folge von Impulsen reagieren, um die Übertragung der Datenuntergruppen aus den Verteilernetzwerken (28, 30, 32, 34) an das Serialisierregister zu steuern.

FIG. 1

+ DATA REGISTER ○───────    ┌─────┐
    BIT 0              ┌───┐  │ AND │ 40
                       │ I │  └─────┘        ┌─────┐ 44
                       └───┘                 │ OR  │───○ 0A DATA TO 36
                        38                   └─────┘
+ DATA REGISTER ○──────      ┌─────┐
    BIT 4                    │ AND │
                             └─────┘
                               42
+ A8 REG. 4 BIT ○──────

## FIG. 2

+ PHASE A DATA    ○────────  ┌─────┐ 46
+ SAMPLE A (CLOCK) ○───────  │ AND │ SAMPLED DATA A
                             └─────┘

+ PHASE B DATA    ○────────  ┌─────┐ 48
+ SAMPLED B (CLOCK) ○──────  │ AND │ SAMPLED DATA B
                             └─────┘                ┌─────┐ 54
                                                    │ OR  │──○ +SERIALIZED
+ PHASE C DATA    ○────────  ┌─────┐ 50             └─────┘      DATA
+ SAMPLED C (CLOCK) ○──────  │ AND │ SAMPLED DATA C
                             └─────┘

+ PHASE D DATA    ○────────  ┌─────┐ 52
+ SAMPLED D (CLOCK) ○──────  │ AND │ SAMPLED DATA D
                             └─────┘

## FIG. 4

2

FIG. 3